# EUROPEAN PATENT APPLICATION

(11) **EP 4 790 434 A1**
(43) Date of publication of application: **12.08.2026**
(21) Application number: 26151951.6
(22) Date of filing: 15.01.2026
(51) Int. Cl.: G01R 31/12, G01R 31/14, G01R 31/34, G01R 31/52

(54) **ELECTRIC MACHINE WITH BUILT-IN SELF-TEST**

(30) Priority: 11.02.2025 GB 202501976
(71) Applicant: Rolls-Royce Deutschland Ltd & Co KG, 15827 Blankenfelde-Mahlow (DE); Rolls-Royce plc, London N1 9FX (GB)
(72) Inventor: HEWITT, David, London, N1 9FX (GB); REEH, Andreas, 15827 Blankenfelde-Mahlow (DE); CHONG, Ellis, London, N1 9FX (GB); JEWELL, Geraint, London, N1 9FX (GB)

(57) **Abstract**

An arrangement (1) for an electric machine (2, 2') comprises: a first winding system (WS1) and a second winding system (WS2), wherein at least one electrical conductor (120) of the first winding system (WS1) and at least one electrical conductor (121) of the second winding system (WS2) are at least partially wound around a common winding axis (A), wherein turns of the electrical conductors (120, 121) alternate in a direction of the winding axis (A); an inverter system (13) with a first inverter (134A) for the first winding system (WS1) and a second inverter (134B) for the second winding system (WS2); sensors (133) for sensing at least one electrical parameter of the first winding system (WS1) and at least one electrical parameter of the second winding system (WS2); and a control unit (131) configured to perform a test of the winding systems (WS1, WS2) by: controlling the first inverter (134A) to set the first winding system (WS1) to a first electrical potential (HV+) and/ot to control the second inverter (134B) to set the second winding system (WS2) to a second electrical potential (HV-) to create a potential difference between the winding systems (WS1, WS2); receiving corresponding sensor signals from the sensors (133); and analyzing the sensor signals.

## Description

### TECHNICAL FIELD

The present disclosure relates in particular to an arrangement for an electric machine, to an electric machine having such an arrangement, and to an aircraft having such an electric machine.

### BACKGROUND

Such arrangements include an electrical winding system. By applying voltages to the winding system, particularly voltages that vary over time, magnetic fields are generated that may cause a rotation of a rotor.

Especially in multiphase rotating field machines, (e.g., having a permanently excited rotor), it is problematic when a winding short circuit occurs in a coil between turns. In particular in such electric machines, the problem exists that, in the event of such a winding short circuit during intended operation, a large electrical current may be induced, which may result in a thermal destruction of the windings. This is particularly relevant not only, but particularly, in aircrafts in which, e.g., permanently excited rotating-field machines are used.

### SUMMARY AND DESCRIPTION

The object of the present disclosure is to provide an improved arrangement for an electric machine. The scope of the present disclosure is defined solely by the appended claims and is not affected to any degree by the statements within this summary. The present embodiments may obviate one or more of the drawbacks or limitations in the related art.

According to one aspect, an arrangement for an electric machine is provided. The arrangement comprises a first winding system and a second winding system wherein at least one electrical conductor of the first winding system and at least one electrical conductor of the second winding system are at least partially wound around a common winding axis, wherein the turns of the different systems alternate in a direction of the winding axis. The arrangement further comprises an inverter system with a first inverter for the first winding system and a second inverter for the second winding system, sensors for sensing at least one electrical parameter of the first winding system and at least one electrical parameter of the second winding system, and a control unit. The control unit is configured to perform a test of the winding systems by controlling the first inverter to set the first winding system to a first electrical potential and/or to control the second inverter to set the second winding system to a second electrical potential to create a potential difference between the winding systems, receiving corresponding sensor signals from the sensors, and analyzing the sensor signals.

The alternating arrangement of the electrical conductors of the two winding systems allow perform the test as described in a simple and reliable manner. In addition, no external test setup is required, so the described functionality may be a built-in self-test of the arrangement. This allows to perform the test regularly, i.e., before each operation of the arrangement (or an electric machine comprising the arrangement). For example, if the arrangement (or an electric machine comprising the arrangement) is part of an aircraft, the test may be performed before starting the aircraft. Such simple and regular testing (in particular, insulation testing) can improve the reliability of the arrangement and electric machine. Thus, an improved arrangement for an electric machine is provided.

The alternating adjacent arrangement of the conductor windings of the first and second winding systems may also be referred to as bifilar arrangement. The electrical conductors of the two winding systems are arranged adjacently in a bifilar manner. The control unit may comprise one or more operatively connected parts that may be located adjacent to one another or displaced with respect to one another. The control unit may be a part of the inverter system. Further, the control unit may at least partially be embodied as software and/or hardware.

The analyzing of the sensor signals may comprise a comparison of the sensor signals (or one or more values deduced therefrom) with at least one reference, e.g., at least one threshold value and/or at least one reference signal.

The first winding system may comprise a number of phases (e.g., three phases) connected to one another with one respective end at a common star point and to an inverter unit of the first inverter with the respective other end. The second winding system may comprise a number of phases (e.g., the same number as the first winding system, e.g., three phases) connected to one another with one respective end at a common star point and to an inverter unit of the second inverter with the respective other end. To create the potential difference, each of the inverter units of the first inverter may be switched to the first electrical potential and each of the inverter units of the second inverter may be switched to the second electrical potential. The first winding system may comprise three electrical conductors connected with each other at the (first) star point. The second winding system may comprise three electrical conductors connected with each other at the (second) star point. The first inverter may provide one respective phase to each of the three electrical conductors of the first winding system. The second inverter may provide one respective phase to each of the three electrical conductors of the second winding system. This allows an efficient operation of the electric machine.

The electrical parameters sensed by the sensors may each be a respective electrical current. By this, an insulation fault may be recognized in a reliable manner. Optionally, the current through each phase of the first and/or second winding system is sensed with a respective sensor. Alternatively, or in addition, the total current drawn by the first inverter and/or by the second inverter may be sensed with a respective sensor.

The control unit may be configured to output a positive test result when the sensed electrical currents are below a maximum value and/or to output a negative test result when the sensed electrical currents are at the maximum value or above. The control unit may be configured to compare the sensor signals with one or more predetermined (e.g., expected) sensor signals, and to detect a fault based on the sensor signals by detecting that a difference between the sensor signals and the one or more expected sensor signals is above or below a given threshold. This provides a reliable result with a simple measurement. Notably, this procedure can be used to detect changes of the winding system, e.g. due to ageing of the insultation. A fault does not have to be present yet. This may be used as a predictive maintenance and/or overhaul function. For example, no fault is present yet, only displacement currents will flow for a very short time (e.g., less than a microsecond). Then the system will be stabilized with opposite potentials of the two systems without further current flow.

The control unit may be configured to perform the test when the rotor of the electric machine stands still. This allows a precise measurement. The built-in test may be performed before a rotor is rotating.

Optionally (e.g., additionally), the control unit is configured to perform the test when the rotor (driven by magnetic fields of the arrangement forming a part of a stator) of the electric machine is rotating. Then, an additional induced voltage will be present. The control unit may be configured to determine the rotational speed of the rotor, to determine the currents induced in the winding systems by the rotating rotor rotating at that speed and to subtract these determined currents from the sensed electrical currents. This allows to perform the test even at times when the arrangement is operating.

According to a further example, the control unit is configured to receive and analyze the sensor signals corresponding to the at least one electrical parameter sensed at a predetermined time after the control unit controlled the first and second inverters to set the potential difference. By this, a transient phase after setting the potential difference may be avoided. The predetermined time may be selected such that the measurement is made in a stable condition after the transient phase.

Alternatively or in addition, the control unit may be configured to receive and analyze sensor signals from the transient phase. For example, the control unit is configured to receive and analyze a time series of the sensor signals corresponding to the at least one electrical parameter sensed within a predetermined time after the control unit controlled the first and second inverters to set the potential difference.

The control unit may be configured to compare the received time series with a stored reference time series to determine a difference therebetween. The control unit may further be configured to output a positive test result when the determined difference is below a maximum difference, and/or to output a negative test result when the determined difference is at the maximum difference or above. This allows a high sensitivity and an early detection of an emerging insulation fault before it becomes potentially problematic.

For example, the control unit is configured to control the second inverter to set the second winding system to the second electrical potential at a predetermined delay after controlling the first inverter to set the first winding system to the first electrical potential (or vice versa). By such a delay an interference between the propagating waves may be created that allows to improve the precision of the test.

For example, the delay is set so as to maximize a constructive interference of voltage wave propagations in the first and second winding systems. This may be sensed and analyzed with an increased precision.

Alternatively, or in addition, the control unit may be configured to control the first inverter and the second inverter to simultaneously set the first winding system to the first electrical potential and the second winding system to the second electrical potential. By this, a simple test setup and analysis is possible.

The control unit may be configured to hold the potential difference between the winding systems for a predetermined period of time and/or until either the test is completed and/or if one of the sensor signals exceeds a predetermined limit. This allows to avoid excessive currents in a case where a fault is indeed present and a precise measurement also in cases where only a first slight degradation of the insulation has occurred.

The first inverter and the second inverter may be powered by the same DC bus This allows a simple setup. The two potentials provided by the DC bus may be the first and second electrical potentials.

According to one aspect, there is provision for an electric machine. The electric machine includes the arrangement according to any configuration described herein, (e.g., including a stator). The electrical machine may further include a rotor, wherein the rotor and the stator are movable relative to each other, in particular rotatable.

According to one aspect, a vehicle, (e.g., an aircraft), is disclosed. The vehicle includes the electric machine according to any configuration described herein, in particular for driving a thrust-generating apparatus, e.g. a propeller. The advantages of the electric machine described herein apply especially to a vehicle, in particular an aircraft. However, the assembly may also be used in a gas pump, in a marine engine, in a wind turbine, or in a generator.

### BRIEF DESCRIPTION OF THE DRAWINGS

Embodiments will now be described by way of example with reference to the figures in which:
- FIG. 1: depicts a schematic sectional illustration of an example of a basic design of a permanently excited, three-phase electric machine having an internal rotor.
- FIG. 2: depicts a schematic, perspective exploded view of an example of a design of an arrangement comprising a stator of the electric machine according to FIG. 1 with tooth windings.
- FIG. 3: depicts a schematic illustration of an example of part of a tooth winding of the arrangement according to FIG. 2, in which turns of a first and second electrical conductor are arranged in a bifilar manner.
- FIG. 4: depicts a schematic illustration of an example of a permanently excited electric machine for operation at a three-phase AC voltage.
- FIGS. 5 and 6: depict schematic circuit diagram illustrations of examples of tooth windings and inverter units of an inverter of the electric machine according to FIG. 2 and FIG. 4, respectively.
- FIG. 7: depicts an example of switching signals for the inverter units.
- FIG. 8: depicts a block diagram of an example of components of the inverter.
- FIGs. 9A, 9B: depict currents in winding systems having no fault.
- FIGs. 10A, 10B: depict currents in winding systems having an insulation fault.
- FIG. 11: depicts calculated currents for insulation faults of different resistances at an arbitrarily selected voltage.
- FIG. 12: depicts a transient phase after applying a potential difference to winding systems of a bifilar machine.
- FIG. 13: illustrates the effect of a delay between switching one winding system to a first electrical potential and another winding system to a second electrical potential.
- FIG. 14: shows a part of an analysis of sensor signals.
- FIG. 15: shows a part of an analysis of sensor signals using a reference sensor signal time series.
- FIG. 16: depicts an example of an aircraft in the form of an airplane having an electrically driven propeller and the electric machine.

### DETAILED DESCRIPTION

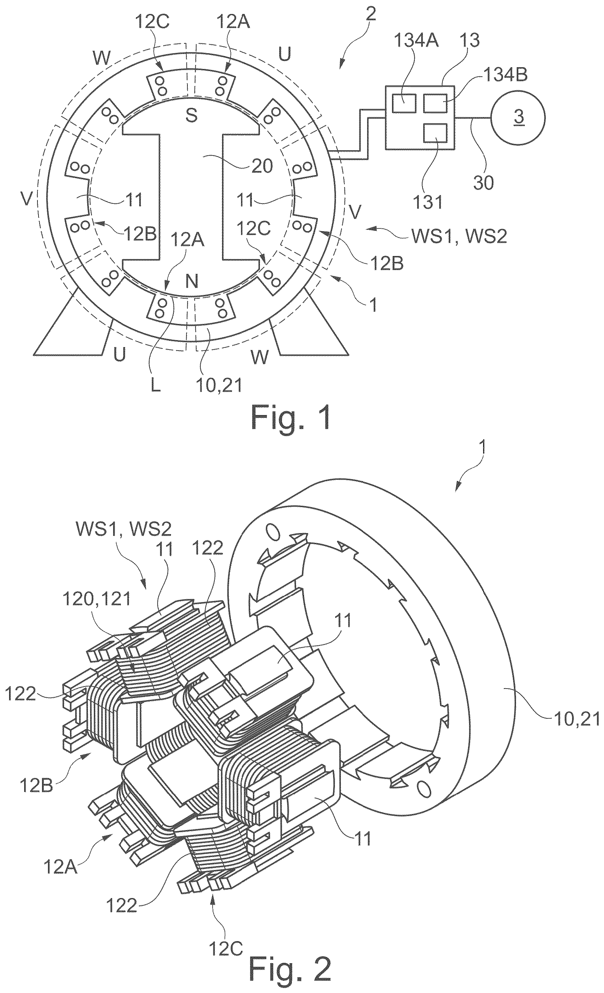

FIG. 1 shows a schematic sectional illustration of a rotating electric machine 2 in the form of a permanently excited synchronous machine. In FIG. 1, the electric machine 2 is in the form of a machine with an internal rotor. The electric machine 2 includes an arrangement 1 that comprises a stator 21 that has an opening, in particular a through-opening in which a rotor 20 is arranged in a rotatably mounted manner.

The stator 21 includes a body 10 in the form of a laminated core, on which teeth are anchored, which are referred to below as stator teeth 11. The stator teeth 11 are aligned with an air gap L between the body 10 of the stator 21 and the rotor 20. The stator teeth 11 protrude radially from the body 10, in the present case radially inward. The stator 21 has a stator winding that includes a plurality of windings 12A-12C (in the form of tooth windings). The stator winding in the present case is designed for three-phase operation, (connected to a three-phase AC voltage having phases U, V, W). During intended operation of the electric machine 2, the AC voltage is accordingly applied to the stator winding.

The rotor 20 is in the form of a salient-pole rotor that includes permanent magnets for providing the magnetic flux. In the present configuration, there is provision for the rotor 20 to have exactly one magnetic north pole N and one magnetic south pole S. In alternative configurations, there may also be provision for more magnetic poles, e.g., in alternation in the circumferential direction transverse to an axis of rotation of the rotor 20 (relative to the stator 21).

The rotor 20 is rotatably mounted. As a result of the three-phase AC voltage, the phases U, V, W thereof each being phase-shifted by 120°, a magnetic rotating field is generated during intended operation, which magnetic rotating field interacts with the permanently excited magnetic field provided by the rotor 20 such that a corresponding rotational movement of the rotor 20 in relation to the stator 21 may be brought about during operation of the motor. In certain examples, the electric machine 2 is used as a drive motor, e.g., for a propeller of an aircraft. The portions of the stator winding assigned to the respective phases U, V, W are schematically illustrated in FIG. 1. One winding 12A-12C is in each case respectively assigned to one of the phases U, V, W.

The stator winding of the electric machine 2 is connected to an inverter system 13 (in this example of a three-phase design). The inverter system 13 provides the electric AC voltage with the three phases U, V, W. The inverter system 13 obtains the electric energy required for the intended operation from an energy source 3 connected to the inverter system 13. In the present configuration, the energy source 3 is a DC voltage source which provides electrical energy from a suitable electrical energy store, for example, a rechargeable battery or the like. Alternatively, or additionally, a fuel cell and/or the like or, in the case of stationary applications, an energy supply from a public energy supply network may be provided, for which purpose a rectifier for converting an alternating current of the public energy supply network into direct current may be provided.

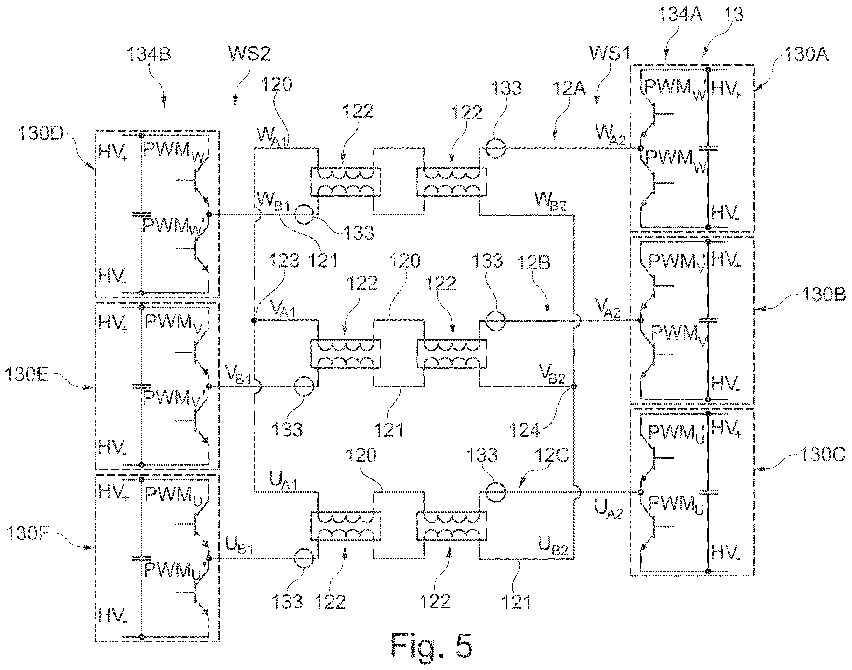

The inverter system 13 has inverter units assigned for providing the phases U, V, W, which inverter units are explained in more detail further below in connection with FIG. 5, for example. In this case, each inverter unit has its own half-bridge circuit. The half-bridge circuits are connected to a DC bus 30 circuit for the inverter system 13, in order to thus be supplied with electrical energy. The DC bus 30 may have a voltage of 25 V or more, 100 V or more, or in the range of 800 to 3000 V.

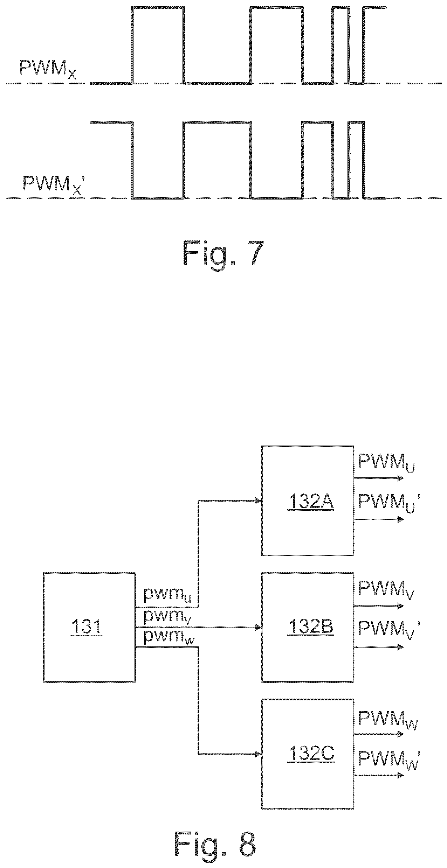

The half-bridge circuit has a series circuit including two electronic switching elements (e.g., transistors) that are connected to the DC bus 30. The electronic switching elements are operated in a clock mode, as explained in more detail below in connection with FIG. 7, which provides a switching signal (e.g., signals for the gate drives) in the manner of a PWM signal, for example. The corresponding phase U, V, W of the three-phase AC voltage is then available at a respective center tap of the half-bridge circuits. Filtering is carried out by the inductance of the windings 12A-12C, with the result that an appropriate AC current is established for each phase U, V, W, which AC current may be virtually sinusoidal if the inverter units are suitably controlled.

The inverter system 13 comprises a first inverter 134A and a second inverter 134B. the first inverter 134A comprises a first set of inverter units, in this example three, i.e., one for each phase U, V, W. The second inverter 134B comprises a second set of inverter units, in this example three, i.e., one for each phase U, V, W. The windings 12A-12C are divided in two winding systems WS1, WS2. Thereof, first winding system WS1 is electrically connected to the first inverter 134A and is not electrically connected to the second inverter 134B. Accordingly, the second winding system WS2 is electrically connected to the second inverter 134B and is not electrically connected to the first inverter 134A. The first inverter 134A can operate the first winding system WS1 independently of the second inverter 134B and second winding system WS2 (and vice versa). If one of the inverters 134A, 134B or one of the winding systems WS1, WS2 fails, the other can still be operated to drive the rotor 20.

For the sake of simplicity, only one energy source 3 is shown. However, more than one energy source can be provided or the energy source 3 may have two or more mutually independent parts. For example, the first inverter 134A is provided with power from a first part of the energy source 3, and the second inverter 134B is provided with power from a second part of the energy source 3.

The inverter system 13 comprises a control unit 131. The control unit 131 controls the inverters 134A, 134B.

For the sake of simplicity, the inverter system 13 is counted here as part of the arrangement 1 and thus as part of the electric machine 2, but may also be described together with it as an electrical drive device.

FIG. 2 shows a schematic exploded illustration of the stator 21 of the electric machine 2. The stator 21 has the body 10 in which the stator teeth 11 may be joined together with the annular body 10 by a mechanical connection and may thus be fixed thereon, in particular, mechanically fixed thereon. Alternatively, the stator teeth 11 may be formed in one piece with the body 10.

The stator teeth 11 are fitted with respective winding portions 122 of the windings 12A-12C. The stator winding has a plurality of windings 12A-12C, (e.g., exactly three windings). A respective one of the windings 12A-12C may be arranged at least on one of the stator teeth 11. In the present case, each winding 12A-12C extends over a plurality of stator teeth 11, (e.g., specifically two opposite stator teeth). For this purpose, each winding 12A-12C may have at least one winding portion 112 or a plurality of winding portions 122 (e.g., two winding portions). Each winding portion 122 surrounds (e.g., exactly) one stator tooth 11. In this example, each winding portion 122 forms a coil. For example, each winding 12A-12C comprises at least one coil or more than one coil. In the present example, each winding 12A-12C comprises two coils.

Each winding 12A-12C has a respective first electrical conductor 120, which at each winding portion 122 is arranged in a plurality of turns circumferentially around the respective stator tooth 11. Between the winding portions 122, the first electrical conductor 120 includes one or more corresponding connecting portions via which the portions of the first electrical conductor 120 at the winding portions 122 are electrically connected to each other.

Each winding 12A-12C further has a respective second electrical conductor 121 that likewise at each winding portion 122 is arranged in a plurality of turns circumferentially around the respective stator tooth 11. Between the winding portions 122, the second electrical conductor 121 includes one or more corresponding connecting portions via which the portions of the second electrical conductor 121 at the winding portions 122 are electrically connected to each other.

The first electrical conductors 120 and the second electrical conductors 121 each have end portions to which they are connected in a manner described in more detail below. Between the respective end portions (and, in this example, over their entire lengths), the first electrical conductors 120 and the second electrical conductors 121 are electrically insulated from each other. The windings 12A-12C are connected in the electric machine 2 such that the three-phase connection to the inverter system 13 is present.

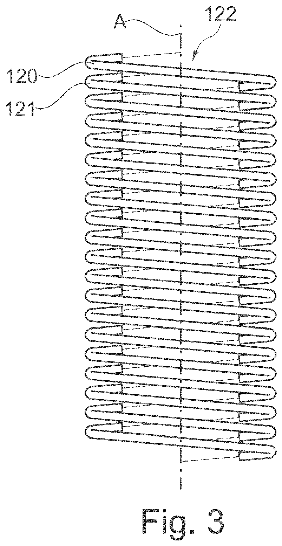

FIG. 3 shows a schematic illustration of a winding portion 122 of one of the windings 12A-12C. The first electrical conductor 120 in this case is wound around the stator tooth 11, which is not illustrated in FIG. 3. The winding on the stator tooth 11 extends here around and along a winding axis A. In the present case, the winding portion 122 is configured in the form of an elongate coil along the winding axis A.

Furthermore, the winding portion 122 of the winding 12A-12C includes the respective second electrical conductor 121 that is electrically insulated from the first electrical conductor 120. The second electrical conductor 121 also has a plurality of turns arranged circumferentially around the same stator tooth 11, so that the winding on the stator tooth 11 extends around and along the winding axis A. The respective turns of the first and second electrical conductors 120, 121 are arranged in a bifilar manner. In other words, one turn of the first electrical conductor 120 is arranged between two adjacent turns of the second electrical conductor 121 (and vice versa) along the winding axis A of the winding portion 122 (with the exception of the outermost two turns). This has the advantage that, in the event of an inter-turn short circuit between two adjacently arranged turns, the inter-turn short circuit occurs between the first electrical conductor 120 and the second electrical conductor 121. An inter-turn short circuit thus does not occur inside a winding of the same electrical conductor. This makes it possible to prevent large currents in the case of an inter-turn short circuit and therefore large thermal and electrical stresses.

Optionally, each first electrical conductor 120 and/or each second electrical conductor 121 includes two or more individual conductors insulated from each other.

Notably, the coils formed by the respective winding portions 122 may be elongate (e.g., in a direction parallel to the rotor 20 rotational axis), as shown in FIG. 2. Here, the winding axis A may be defined to be at a position inside the coil, e.g., in the center of the coil. More complicated coil shapes are also possible, such as bent along the longitudinal axis, particular for alternative machine topologies such as a transverse flux machine or the like.

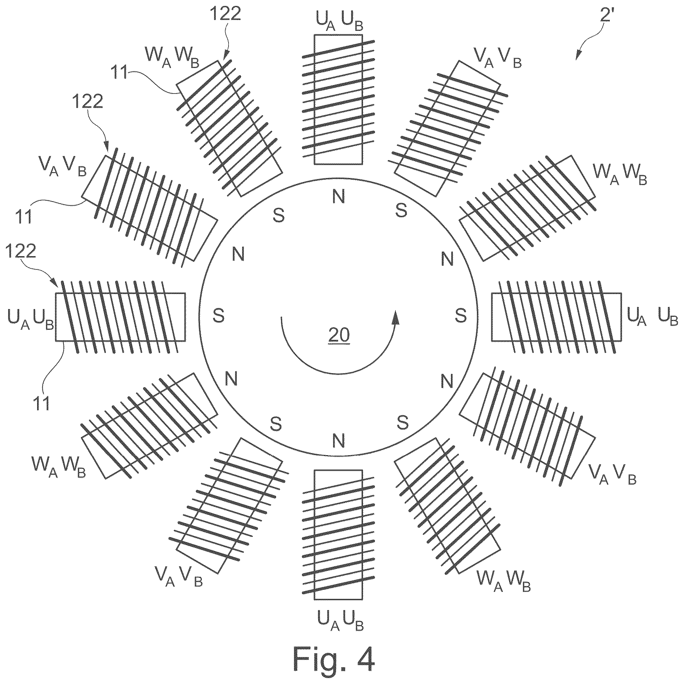

FIG. 4 shows a schematic illustration of an electric machine 2' in the form of a synchronous machine that, in contrast to the electric machine 2 according to FIGS. 1 and 2, now has a twelve-pole rather than a six-pole design. The corresponding stator therefore has twelve stator teeth 11. These are arranged equidistantly in the circumferential direction in the present case. The rotor 20 is again arranged in a through-opening formed by the stator, which rotor likewise has a twelve-pole design in this configuration and therefore provides six north poles N and six south poles S arranged in alternation in the circumferential direction. Here too, the magnetic flux provided by the rotor 20 is provided by permanent magnets arranged, e.g., in the region of the outer circumference of the rotor 20. The numbers of poles are provided by way of example and other numbers are also possible.

Each stator tooth 11 of the stator teeth 11 is also equipped here with a winding portion 122 of one of the three windings 12A-12C. Each winding of the three windings 12A-12C again has a respective first electrical conductor and a respective second electrical conductor (illustrated by different line thicknesses in FIG. 4 purely for the purposes of illustration) that are wound onto the respective stator teeth 11 in a bifilar manner. This electric machine 2' is likewise designed to be supplied with a three-phase AC voltage, wherein each of the phases is again denoted using U, V, W.

The electric machines 2, 2' described with reference to FIGS. 1-4 are inner-runner radial flux machines. Notably, the principles described herein can also be applied to outer-runner radial flux machines as well as to a transverse flux machine and to an axial flux machine.

FIG. 5 shows an electrical interconnection of the windings 12A-12C and the inverter units 130A-130F of the inverter system 13 of the electric machine 2 according to FIG. 1.

The first electrical conductors 120 (e.g., three first electrical conductors) of the windings 12A-12C form a first winding system WS1 and the second electrical conductors 121 (e.g., three second electrical conductors) of the windings 12A-12C form a second winding system WS2. The first winding system WS1 is connected to three inverter units 130A-130C. These three inverter units 130A-130C form the first three-phase inverter 134A. Each first electrical conductor 120 is connected with an end portion WA2, VA2, UA2 thereof to one of the inverter units 130A-130C. The respective other end portions WA1, VA1, UA1 of the first electrical conductors 120 are electrically connected to each other at a first star point 123.

The second winding system WS2 is connected to further three inverter units 130D-130F. These further three inverter units 130D-130F form the second three-phase inverter 134B. Each second electrical conductor 121 is connected with an end portion WB1, VB1, UB1 to one of the inverter units 130D-130F. The respective other end portions WB2, VB2, UB2 of the second electrical conductors 121 are electrically connected to each other at a second star point 124.

The inverter system 13 thus includes six inverter units 130A-130F, two for each of the three phases U, V, W, and of these two inverter units, one each for the first winding system WS1 and one for the second winding system WS2. As already described, each inverter unit 130A-130D has a half-bridge circuit. An optional capacitor is used as a low-pass filter in each case.

The (e.g., same) DC bus 30 voltage (designated by HV+ and HV-) is applied to the inverter units 130A-130F of both inverters 134A, 134B of the inverter system 13. For example, the DC voltage is 25 V or more, 100 V or more, or in a range of 800 to 3000 V.

Furthermore, all six winding portions 122 for the six stator teeth 11 are shown, wherein each winding of the first and second electrical conductors 120, 121 is illustrated only schematically.

First, the winding 12A for a first phase W will be considered. This winding 12A includes a first electrical conductor 120 and a second electrical conductor 121. Both electrical conductors 120, 121 extend over winding portions 122 on the same (e.g., one or more, in this example two) stator teeth 11 but are insulated from one another. Both electrical conductors 120, 121 have the aforementioned two end portions WA1, WA2, WB1, WB2. Here, both electrical conductors 120, 121 are free of junctions between their end portions WA1, WA2, WB1, WB2. The electrical conductors 120, 121 each establish an electrical connection between the respective two end portions WA1, WA2, WB1, WB2. The winding portions 122 of the winding 12A lie between the end portions WA1, WA2, WB1, WB2 of the electrical conductors 120, 121.

One end portion WA2 of the first electrical conductor 120 is electrically connected to a first inverter unit 130A of the inverter system 13, and the other end portion WA1 of the first electrical conductor 120 is electrically connected to the first star point 123. One end portion WB1 of the second electrical conductor 121 is electrically connected to a fourth inverter unit 130D of the inverter system 13, and the other end portion WB2 of the second electrical conductor 121 is electrically connected to the second star point 124.

The end portions of the first electrical conductor 120 of the winding 12B for a second phase V are denoted using VA1 and VA2. One end portion VA2 of the first electrical conductor 120 is electrically connected to the inverter system 13, specifically, to a second inverter unit 130B thereof, and the other end portion VA1 of the first electrical conductor 120 is electrically connected to the first star point 123.

The end portions of the second electrical conductor 121 of the winding 12B for the second phase V are correspondingly denoted using VB1 and VB2. One end portion VB1 of the second electrical conductor 121 is electrically connected to the inverter system 13, specifically, to a fifth inverter unit 130E thereof, and the other end portion VB2 of the second electrical conductor 121 is electrically connected to the second star point 124.

The end portions of the first electrical conductor 120 of the winding 12C for a third phase U are denoted using UA1 and UA2. One end portion UA2 of the first electrical conductor 120 is electrically connected to the inverter system 13, specifically to a third inverter unit 130C thereof, and the other end portion UA1 of the first electrical conductor 120 is electrically connected to the first star point 123.

The end portions of the second electrical conductor 121 of the winding 12C for the third phase U are correspondingly denoted using UB1 and UB2. One end portion UB1 of the second electrical conductor 121 is electrically connected to the inverter system 13, specifically, to a sixth inverter unit 130F thereof, and the other end portion UB2 of the second electrical conductor 121 is electrically connected to the second star point 124.

The arrangement 1 comprises the first winding system WS1 and the second winding system WS2. The winding systems WS1, WS2 are electrically disconnected (and isolated) from one another. As described above, the two winding systems WS1, WS2 have electrical conductors 120, 121 that form a plurality of coils in a bifilar arrangement. At least one (first) electrical conductor 120 (in the present example three electrical conductors 120) of the first winding system WS1 and at least one (second) electrical conductor 121 (in the present example three electrical conductors 121) of the second winding system WS2 are at least partially wound around a common winding axis A that alternate between winding systems in a direction of the winding axis A (e.g., as shown in Fig. 4). In the direction of the winding axis A, each turn of the first electrical conductor 120 within the coil is arranged (directly) between two turns of the second electrical conductor 121 (isolated from one another). Correspondingly, in the direction of the winding axis A, each turn of the second electrical conductor 121 within the coil is arranged (directly) between two turns of the first electrical conductor 120 (isolated from one another). Denoting the first electrical conductor 120 as "A" and the second electrical conductor 121 as "B", the arrangement along the winding axis A may be A-B-A-B (and so forth).

The arrangement 1 further comprises the inverter system 13 which includes the first inverter 134A for the first winding system WS1 and the second inverter 134B for the second winding system WS2.

The control unit 131 of the inverter system 13 may comprise several blocks or components that may be embodied as software and/or hardware and that may be located adjacent or distant to one another.

As another example, each of the first and second inverters may comprise a full-bridge circuit for each of the phases U, V, W of the respective winding system. Specifically, each of the first and second inverters 134A, 134B may comprise two phase units for each phase U, V, W, wherein an electrical conductor of each of the electrical phases U, V, W is connected between the respective two phase units. Thus, each winding system comprises six phase units. Each of the phase units has two switching elements connected in series and is connected to a DC voltage intermediate circuit of the inverter. The respective phase U, V, W of the multiphase electrical AC voltage may be provided at a center tap between the switching elements. Such a circuit arrangement has no star point and allows precise control.

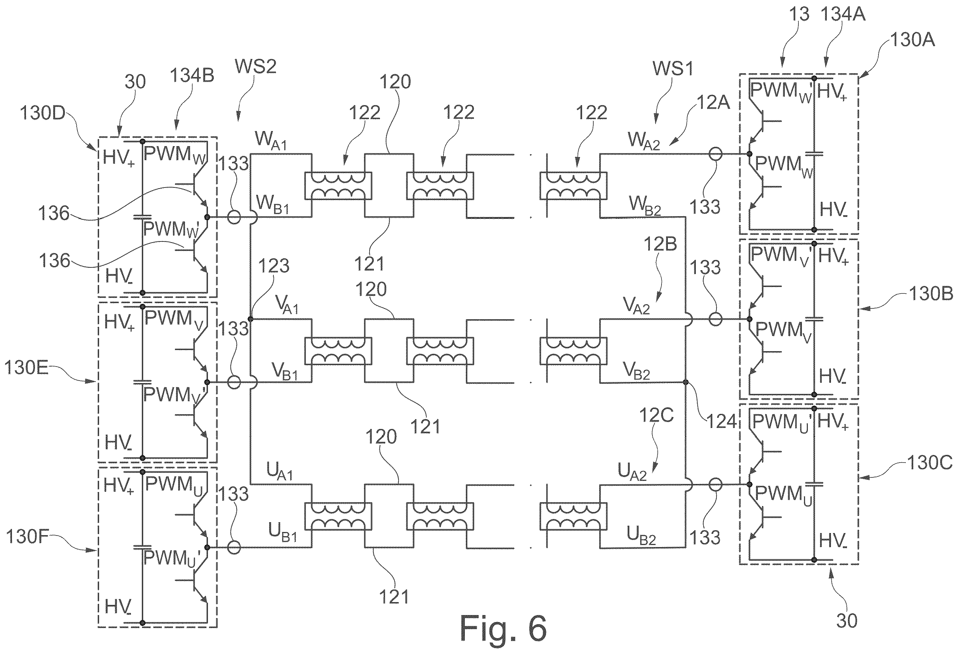

FIG. 6 shows substantially the same circuitry as FIG. 5, wherein more winding portions 122 are illustrated. It can be seen that the windings 12A-12C may have a smaller or larger number of winding portions 122 depending on the application, e.g., in total six (cf. in particular FIGS. 2 and 5), twelve (cf. in particular FIG. 4), or 18, to name just some examples.

While the windings 12A-12C are arranged between the inverter units 130A-130F according to FIGS. 5 and 6, this arrangement is only exemplary. Indeed, the inverters 134A, 134B may be electrically connected to the winding systems WS1, WS2 from the opposite ends, as shown in FIGs. 5 and 6, or from the same ends. In the latter case, the star points 123, 124 would be one the same side of the windings 12A-12C.

Furthermore, it may be seen that in FIGS. 5 and 6 the end portions, connected to the inverter units 130A-130F, of the first and second conductors 120, 121 of each individual one of the windings 12A-12C face away from one another with respect to the common winding portions 122.

To create the alternating three-phase voltage, currents introduced into the electrical conductors 120, 121 are controlled by switching the transistors (or other types of switches 136) of the inverter units 130A-130F. The transistors are controlled by signals, in the present case by pulse width modulated signals, which may also be referred to as PWM signals for short (pulse width modulation). The PWM signals alternate between two discrete values, e.g., "on" and "off", which open and close the corresponding transistor (or other type of switch), respectively.

FIG. 7 shows an example of such PWM signals, wherein X stands for the respective phase U, V, W. The PWM signals for the individual phases U, V, W are, e.g., the same, only shifted in time.

Furthermore, an inverted PWMX' signal is provided for each PWMX signal, which assumes the corresponding opposite discrete value in relation to the PWMX signal over time. The PWMX' signal corresponds to the inverted PWMX signal.

As illustrated, e.g., with reference to FIGS. 5 and 6, for each winding 12A-12C, the reverse PWM signal PWMW', PWMV', PWMU' is applied to the respective transistor of the inverter unit 130A, 130B, 130C of the first electrical conductor 120 connected to the positive electric potential HV+ of the DC voltage. By contrast, the PWM signal PWMW, PWMV, PWMU is applied to the transistor of the inverter unit 130A, 130B, 130C of the first electrical conductor 120 connected to the negative electric potential HV- of the DC voltage.

In the second electrical conductors 121, the PWM signals are applied in reverse. The PWM signal PWMW, PWMV, PWMU is applied to the transistor of the inverter unit 130D, 130E, 130F of the second electrical conductor 121 connected to the positive electric potential HV+ of the DC voltage. By contrast, the reverse PWM signal PWMW', PWMV', PWMU' is applied to the transistor of the inverter unit 130D, 130E, 130F of the second electrical conductor 121 connected to the negative electric potential HV- of the DC voltage.

It may therefore be seen that the same PWM signals may be applied to the inverter units 130A-130C of the first electrical conductor 120 as to the inverter units 130D-130F of the second electrical conductor 121.

FIG. 8 illustrates a possible generation of the PWM signals PWMX and the reverse PWM signals PWMX'. The control unit 131 of the inverter system 13 generates signals for the three phases U, V, W, which are designated here as pwmu, pwmv, pwmw. These are each provided to a power electronics driver 132A-132C, which generate the respective PWM signals and reverse PWM signals for the corresponding phase U, V, W based on them. The power electronics drivers 132A-132C are connected (e.g., electrically) to the inverter units 130A-130F of the respective phase U, V, W.

Returning to FIG. 5, the arrangement 1 comprises a plurality of sensors 133, each of the plurality of sensors 133 being configured for sensing at least one electrical parameter. At least one sensor 133 is arranged to sense the at least one electrical parameter at (and of) the first winding system WS1. At least one sensor 133 is arranged to sense the at least one electrical parameter at (and of) the second winding system WS2. In the present example, a plurality of sensors 133 is arranged to sense a respective electrical parameter at (an of) the first winding system WS1 and a plurality of sensors 133 is arranged to sense a respective electrical parameter at (an of) the second winding system WS2. Here, the electrical parameters are electrical currents. Each one sensor 133 is arranged to sense the strength of the current through each phase U, V, W of each of the winding systems WS1, WS2, so, in the present example, six sensors 133 are provided (although other numbers are also possible). The sensors 133 generate sensor signals that are indicative of the respective electrical parameter, in the present example the current through the respective conductor.

In case of an insulation fault such as an inter-turn short circuit, the resistance between the winding systems WS1, WS2 changes. To detect an insulation fault based on the sensor signals, the control unit 131 is further configured to perform an insulation test by applying the following steps:
a) Control the first inverter 134A to set the first winding system WS1 to a first electrical potential, e.g., HV+, and to control the second inverter 134B to set the second winding system WS2 to a second electrical potential, e.g., HV-, to create a potential difference between the winding systems WS1, WS2. Here, the entire first winding system WS1 is constantly (for a certain time period) is set to the first electrical potential and the entire second winding system WS2 is constantly set to the second electrical potential. Before the switching, the winding systems WS1, WS2 may have been in a neutral state, e.g., on ground level and/or on a potential that equals (first electrical potential + second electrical potential) / 2. For example, the switching is performed in a state where both winding systems WS1, WS2 are on the same potential, e.g., in the middle between the first and second potentials. However, it is also possible to start with both winding systems WS1, WS2 on the first electrical potential or on the second electrical potential, and then only switch one of the winding systems WS1, WS2 to the other electrical potential to create the potential difference. After the switching, the two inverters 134A, 134B correspond to a zero vector.
b) Receive the sensor signals from the sensors 133. Here, the control unit 131 measures the current through each of the phases U, V, W. Alternatively, the current through at least one of the phases of each winding system WS1, WS2 may be measured.
c) Analyzing the sensor signals. By the bifilar arrangement in combination with the switching to the two different potentials, the sensor signals reflect a fault. Several specific examples for such an analysis will be described in the following.

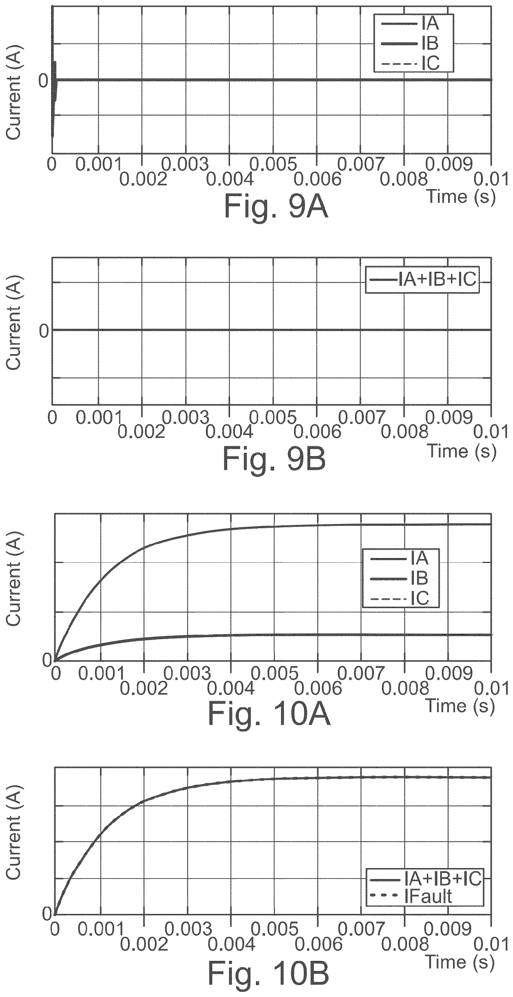

For a first example, reference is made to FIGs. 9A to 10B. FIG. 9A shows the sensor signals of the sensors 133 of one of the winding systems WS1, WS2, denoted by IA, IB, IC, when the electrical machine 2, 2' is in a healthy condition without a fault. Only in the very first instances of time (visible in the left end of this figure) a transient fluctuation of the current is registered. After this transient period, the currents (all curves are lying on top of one another) are all constantly at 0 A. FIG. 9B shows the sum of the three measured currents IA, IB, IC, indicating the same constant 0 A value after the transient beginning until 0,01 s shown in FIGs. 9A and 9B corresponding to the example duration of this measurement.

However, if the insulation has a fault between the two winding systems WS1, WS2, a current flows from one to the other. In accordance with the inductance of the winding systems WS1, WS2, this current builds up until it reaches a stable value.

Therefore, according to this example, the control unit 131 is configured to output a positive test result (no insulation fault detected) when the sensed electrical currents are below a maximum value, and to output a negative test result (insulation fault detected) when the sensed electrical currents are at the maximum value or above. So, when comparing each phase current or the sum of the phase currents with the maximum value (above 0 A and below the stable value), the control unit 131 can determine if there is a fault, or not.

Notably, the control unit 131 is configured to perform the test when the rotor 20 of the electric machine 2, 2' is at standstill, i.e., does not rotate relative to the stator 21. However, the control unit 131 can additionally or alternatively be configured to perform the test when the rotor 20 of the electric machine 2, 2' is rotating. In this case, the control unit 131 may be further configured to determine the rotational speed of the rotor 20 relative to the stator 21, to determine (e.g., calculate) the currents induced in the winding systems WS1, WS2 by this rotation of the rotor 20. Without a fault, there should be no current flow (except for the transient displacement current effect, e.g., in the first 100 microseconds). By this, the test can also be performed during operation.

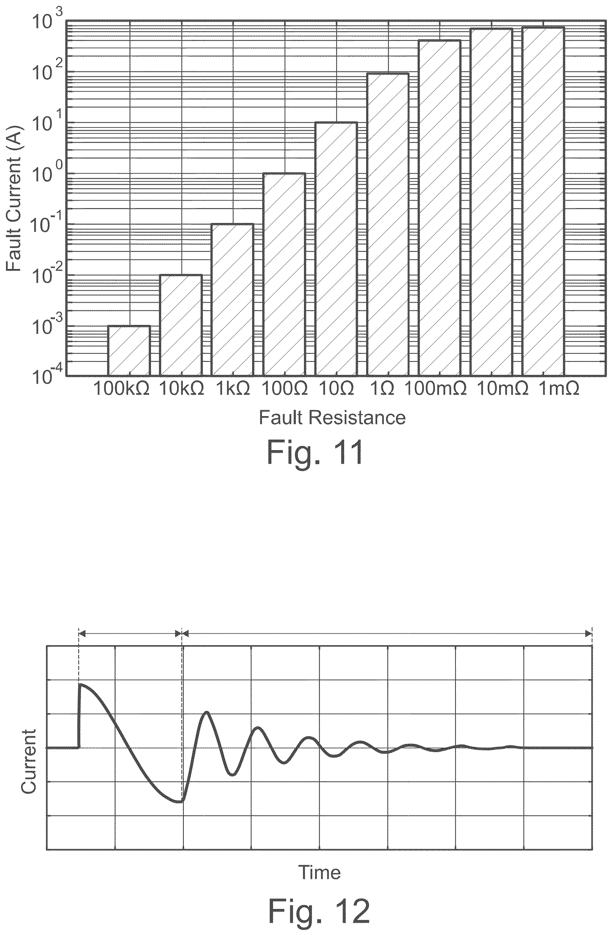

FIG. 11 shows corresponding fault currents at various example fault resistances for an example voltage. Here, even a high resistance of 100 kOhm leads to a current of 1 mA. This is a current which can be measured precisely with typical current sensors. Particularly when the electric machine 2, 2' is at standstill when the test is performed, there is only very little noise in the measurement (no inductance of the rotor 20, no switching noise). On the other hand, 100 kOhm is still a very high resistance. Such a resistance may be a very early indication of a potential fault that emerges in the future. So, the described test can be an early indicator and a measurement over a wide range of currents is possible. The test can be performed before each flight or other operation of the electric machine 2, 2'. When the machine is not running, the zero vectors, i.e., switching states 111 (all high side switches conducting) and 000 (all low side switches conducting) can be used to create the potential difference between the two systems.

If the resistance is already very low, the current drawn in the measurement can be high enough to heat the electric machine 2, 2'. Therefore, the control unit 131 may be configured to hold the potential difference between the winding systems WS1, WS2 only until the test is completed, wherein the test may have a maximum duration of, e.g., 0,01 s. Further, it can be provided that the potential difference is shut off if one of the sensor signals exceeds a predetermined limit, e.g., when a threshold current is exceeded.

As another example, alternatively, or in addition to the stable measurement of the constant current, which is made after the transient period, particularly this transient period may be measured.

FIG. 12 shows the very first instances of time of FIG. 9A after setting up the potential difference. Between the dashed lines, there is a pulse application area which is followed by a decaying eigenfrequency oscillation. The shape of this decaying oscillation strongly depends on the insulation condition of the winding systems WS1, WS2.

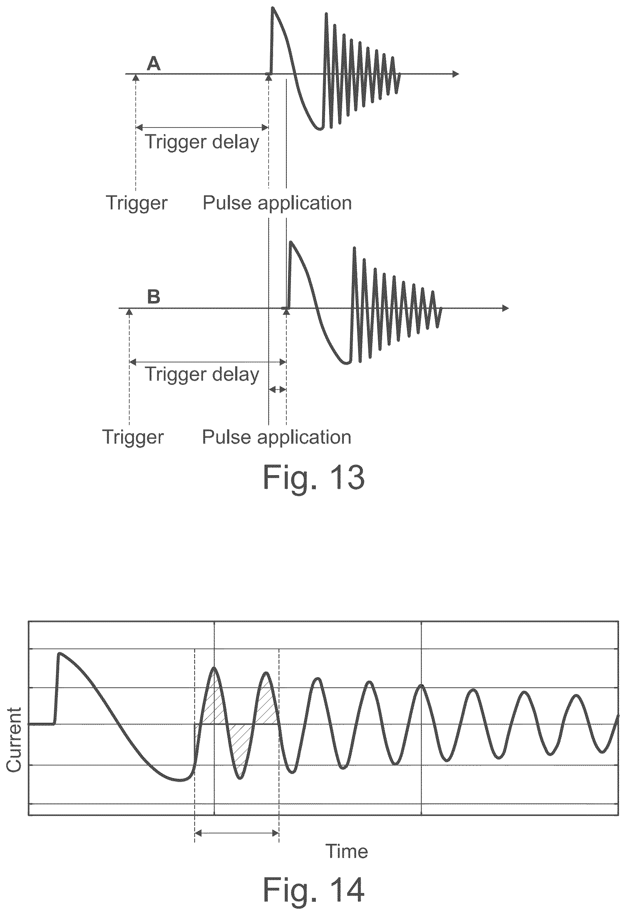

Optionally, a delayed pulse application may be performed as illustrated in FIG. 13. For this purpose, the control unit 131 is configured to control the second inverter 134B to set the second winding system WS2 to the second electrical potential at a given delay after controlling the first inverter 134A to set the first winding system WS1 to the first electrical potential (or vice versa). By this, the two voltage waves may constructively interfere maximizing the voltage difference between the system and, thereby, result in an even higher current for one or few periods. Alternatively, both switching processes may be performed simultaneously. In the latter case, the control unit 131 is configured to control the first inverter 134A and the second inverter 134B to simultaneously set the first winding system WS1 to the first electrical potential and the second winding system WS2 to the second electrical potential.

Two examples to analyze the transient period are presented. One is illustrated in FIG. 14. Therein, the total area under the curve of the current at a given time after triggering the switching is measured. This measured area M can be compared to a reference area R by: X = (M / R - 1) * 100, a percentual difference is obtained. Here, the percentual difference between the measured and the reference area can be compared to a threshold to decide whether a fault is present or not.

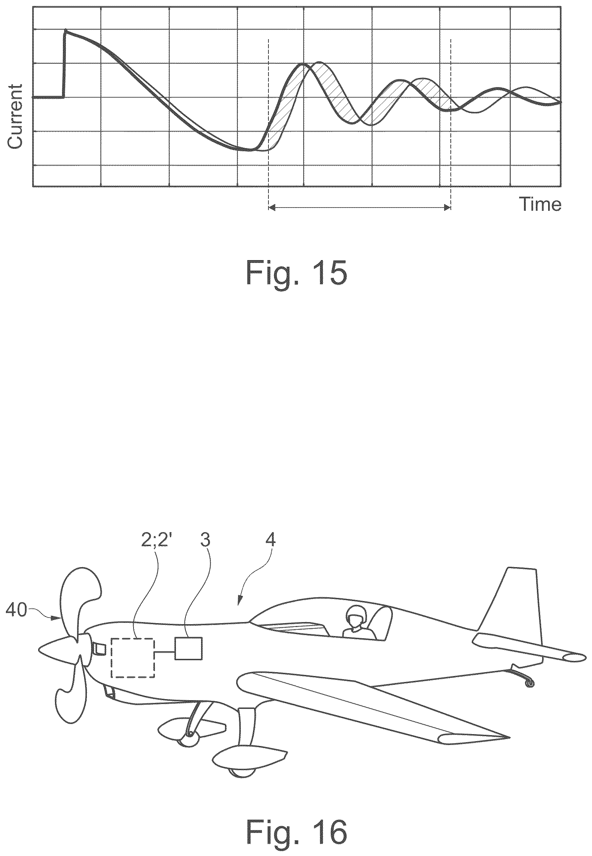

Another example is illustrated in FIG. 15. Therein, it is shown that a differential surface area calculation can be performed. Here, the area between the measured curve of a reference curve can be determined as [(M - R) / R] *100. The percentual differential value can be compared to a threshold to decide whether a fault is present or not.

Notably, it is also possible to only switch one of the winding systems to a different potential (e.g., starting from the same potential) and to measure the effect on the other winding system as described in particular with reference to FIGs. 14 and 15. Due to the capacitive and inductive coupling the measurement can be used for further winding insulation system characterization.

The currents may be recoded as a time series of measured values. The comparison of the measured time series with the reference time series allows a fast and precise measurement.

The proposed tests are simple to implement and do not involve further sensors apart from the current sensors 133 in at least one location, here at each inverter 134A, 134B phase output. Further, the direct current injection has been found to be more reliable and robust than an HF signal injection. Notably, when connecting each of the systems to an opposing potential, there will be a voltage wave propagating into each system. As the capacitance between the bifilar systems is charging (like a capacitor) there will be displacement current flow if no fault is present. This short-term displacement current flow could be interpreted as a current waveform since it depends on the evolution of the voltage waves.

When a fault (e.g., an inter-turn short circuit) is detected, the control unit 131 optionally switches off all PWM signals (e.g., to zero). Optionally, the positive and or the negative pole HV+, HV- of the DC bus 30 are disconnected from the inverter units 130 A-130F. The control unit 131 may cause a three-phase short circuit.

The control unit 131 may initiate other countermeasures. Alternatively, the error may first be displayed to a user. As a countermeasure one or both potential connections may be disconnected again such that there is no potential difference anymore.

Alternatively, or additionally to the above-described fault detection, a voltage may be measured, e.g., at the star points 123 and 124 and/or a magnetic field can be measured, e.g., using a Hall sensor.

FIG. 16 shows an aircraft 4 in the form of an electrically driven airplane. The aircraft 4 includes a propeller 40 which is driven by the above-described electric machine 2 according to FIG. 2 (alternatively by the electric machine 2' according to FIG. 4).

The aircraft 4 furthermore includes an energy source 3 in the form of an electric battery. The electric machine 2 is supplied with energy by the energy source 3, wherein the energy source 3 is electrically connected to the inverter system 13.

Notably, the bifilar system does not have to be composed of three-phase winding subsystems. Any multi-phase configuration enabling potential differences between the turns of the two winding sets in the built-in test are conceivable.

The disclosure is not limited to the embodiments described above, and various modifications and improvements may be made without departing from the concepts described here. Any of the features may be used separately or in combination with any other features, unless they are mutually exclusive, and the disclosure extends to and includes all combinations and sub-combinations of one or more features that are described herein.

It is to be understood that the elements and features recited in the appended claims may be combined in different ways to produce new claims that likewise fall within the scope of the present disclosure. Thus, whereas the dependent claims appended below depend on only a single independent or dependent claim, it is to be understood that these dependent claims may, alternatively, be made to depend in the alternative from any preceding or following claim, whether independent or dependent, and that such new combinations are to be understood as forming a part of the present specification.

While the present disclosure has been described above by reference to various embodiments, it may be understood that many changes and modifications may be made to the described embodiments. It is therefore intended that the foregoing description be regarded as illustrative rather than limiting, and that it be understood that all equivalents and/or combinations of embodiments are intended to be included in this description.

### LIST OF REFERENCE SIGNS

- 1: arrangement
- 10: body
- 11: stator tooth
- 12A-12C: winding
- 120: first electrical conductor
- 121: second electrical conductor
- 122: winding portion
- 123: first star point
- 124: second star point
- 13: inverter system
- 130A-130F: inverter unit
- 131: control unit
- 132A-132C: power electronics driver
- 133: sensor
- 134A, 134B: inverter
- 136: switch
- 2, 2': electric machine
- 20: rotor
- 21: stator
- 3: energy source
- 30: DC bus
- 4: aircraft
- 40: propeller
- A: winding axis
- L: air gap
- N: north pole
- S: south pole
- U, V, W: phase
- WS1, WS2: winding system

## Claims

1. An arrangement (1) for an electric machine (2, 2'), the arrangement (1) comprising:
- a first winding system (WS1) and a second winding system (WS2), wherein at least one electrical conductor (120) of the first winding system (WS1) and at least one electrical conductor (121) of the second winding system (WS2) are at least partially wound around a common winding axis (A), wherein turns of the electrical conductors (120, 121) alternate in a direction of the winding axis (A);
- an inverter system (13) with a first inverter (134A) for the first winding system (WS1) and a second inverter (134B) for the second winding system (WS2);
- sensors (133) for sensing at least one electrical parameter of the first winding system (WS1) and at least one electrical parameter of the second winding system (WS2); and
- a control unit (131) configured to perform a test of the winding systems (WS1, WS2) by:
∘ controlling the first inverter (134A) to set the first winding system (WS1) to a first electrical potential (HV+) and/or to control the second inverter (134B) to set the second winding system (WS2) to a second electrical potential (HV-) to create a potential difference between the winding systems (WS1, WS2);
∘ receiving corresponding sensor signals from the sensors (133); and
∘ analyzing the sensor signals.

2. The arrangement (1) of claim 1, wherein the first winding system (WS1) comprises a number of phases connected to one another with one respective end at a common star point (123) and to an inverter unit (130A-130C) of the first inverter (134A) with the respective other end and the second winding system (WS2) comprises a number of phases connected to one another with one respective end at a common star point (124) and to an inverter unit (130D-130F) of the second inverter (134B) with the respective other end, wherein, to create the potential difference, each of the inverter units (130A-130C) of the first inverter (134A) is switched to the first electrical potential (HV+) and each of the inverter units (130D-130F) of the second inverter (134B) is switched to the second electrical potential (HV-).

3. The arrangement (1) of claim 1 or 2, wherein the electrical parameters sensed by the sensors (133) are respective electrical currents.

4. The arrangement (1) of claim 3, wherein the control unit (131) is configured to output a positive test result when the sensed electrical currents are below a maximum value, and to output a negative test result when the sensed electrical currents are at the maximum value or above.

5. The arrangement (1) of any of the preceding claims, wherein the control unit (131) is configured to perform the test when a rotor (20) of the electric machine (2, 2') stands still, and/or when a rotor (20) of the electric machine (2, 2') is rotating.

6. The arrangement (1) of any of the preceding claims, wherein the control unit (131) is configured to receive and analyze the sensor signals corresponding to the at least one electrical parameter sensed at a predetermined time after the control unit (131) controlled the first and second inverters (134A, 134B) to set the potential difference.

7. The arrangement (1) of any of claims 1 to 5, wherein the control unit (131) is configured to receive and analyze a time series of the sensor signals corresponding to the at least one electrical parameter sensed within a predetermined time after the control unit (131) controlled the first and second inverters (134A, 134B) to set the potential difference.

8. The arrangement (1) of claim 7, wherein the control unit (131) is configured to compare the received time series with a stored reference time series to determine a difference therebetween, and to output a positive test result when the determined difference is below a maximum difference, and to output a negative test result when the determined difference is at the maximum difference or above.

9. The arrangement (1) of any of the preceding claims, wherein the control unit (131) is configured to control the second inverter (134B) to set the second winding system (WS2) to the second electrical potential (HV-) at a predetermined delay after controlling the first inverter (134A) to set the first winding system (WS1) to the first electrical potential (HV+).

10. The arrangement (1) of claim 9, wherein the delay is set so as to maximize a constructive interference of voltage wave propagations in the first and second winding systems (WS1, WS2).

11. The arrangement (1) of any of claims 1 to 8, wherein the control unit (131) is configured to control the first inverter (134A) and the second inverter (134B) to simultaneously set the first winding system (WS1) to the first electrical potential (HV+) and the second winding system (WS2) to the second electrical potential (HV-).

12. The arrangement (1) of any of the preceding claims, wherein the control unit (131) is configured to hold the potential difference between the winding systems (WS1, WS2) until either the test is completed or if one of the sensor signals exceeds a predetermined limit.

13. The arrangement (1) of any of the preceding claims, wherein the first inverter (134A) and the second inverter (134B) are powered by the same DC bus (30).

14. An electric machine (2, 2'), comprising the arrangement (1) of any of the preceding claims, the arrangement (1) comprising a stator (21), wherein a rotor (20) is rotatably mounted at the stator (21).

15. An aircraft (4) comprising the electric machine (2, 2') of claim 14.
